# EUROPEAN PATENT SPECIFICATION

(11) **EP 0 343 609 B1**
(45) Date of publication and mention of the grant of the patent: **30.08.1995**
(21) Application number: 89109291.8
(22) Date of filing: 23.05.1989
(51) Int. Cl.: G03F 7/00, H01J 29/07, H01J 9/14

(54) **Method of manufacturing main plates for exposure printing**
Verfahren zur Herstellung von Druckplatten
Procédé de fabrication de plaques d'impression

(30) Priority: 24.05.1988 JP 124911/88
(43) Date of publication of application: 29.11.1989
(73) Proprietor: KABUSHIKI KAISHA TOSHIBA, Kawasaki-shi, Kanagawa-ken 210 (JP)
(72) Inventor: Tanaka, Hiroshi Intellectual Prop. Div., Minato-ku Tokyo 105 (JP); Kudou, Makoto Intellectual Prop. Div., Minato-ku Tokyo 105 (JP)
(74) Representative: Henkel, Feiler, Hänzel & Partner

(56) References cited:
- US-A- 3 973 964
- PATENT ABSTRACTS OF JAPAN, vol. 2, no. 68 (E-78)[2410], 24th May 1978 & JP-A-53 3568
- PATENT ABSTRACTS OF JAPAN, vol. 8, no. 181 (E-261)[1618], 21st August 1984 & JP-A-59 73 834

## Description

This invention relates to a method of manufacturing main plates for exposure printing, and particularly to a method of manufacturing a pair of main plates for printing a predetermined pattern on photo-sensitive layers respectively formed on both faces of a shadow mask of a color cathode ray tube when the shadow mask is manufactured by a photo-etching method.

A color cathode ray tube of shadow mask type is provided with a panel having a substantially rectangular face plate and a skirt extending from a peripheral edge of the face plate, a funnel connected to the panel, and a neck continuous to the funnel. The panel, funnel and neck holds the interior of the color cathode ray tube in vacuum. Within the neck is housed an electron gun assembly which generates electron beams. A deflection yoke which generates magnetic fields is mounted on the outer lateral surfaces of the funnel and the neck. A phosphor screen is formed on the inner face of the face plate of the panel. In the tube, a substantially rectangular shadow mask is disposed to be separated from the face plate at a predetermined distance so as to face the phosphor plate. The shadow mask is made of a thin metal plate and is formed with a great number of apertures. A mask frame surrounds the shadow mask. A plurality of elastically deformable mask supports are welded to the frame. Stud pins engaged with the supports are provided on the inner face of the panel.

With the color ray tube of shadow mask type, the three electron beams emitted from the electron gun assembly are deflected horizontally and vertically by the magnetic field generated by the deflection yoke, and thereafter are converged into apertures of the shadow mask. The electron beams converged at the apertures of the shadow mask are landed on the phosphor screen formed on the face plate of the panel. The phosphor screen has three kinds of phosphor stripes which are alternately arranged. When these phosphor stripes are shot by the three electron beams passing through the apertures of the shadow mask, these phosphor stripes emit three color lights of red, green and blue. In other words, the apertures of the shadow mask serve to direct the three beams to the predetermined phosphor stripes which respectively emit red, green and blue lights.

The shadow mask has a great number of apertures which open at the side of the phosphor screen and at the side of the electron gun. The openings of the apertures at the side of the phosphor screen are larger than the openings of the apertures at the side of the electron gun, and the approximately middle portion of the holes has the minimum diameter, such that each aperture has a so-called drum shape.

The apertures of the shadow mask are formed by the photo-etching method. The shadow mask is made of a plate-like shadow mask material of low carbon steel or the like. Photo-sensitive layers are formed on both the faces of the shadow mask material. A pair of main plates each formed with a pattern corresponding to the apertures of the shadow mask are closely contacted with the respective photo-sensitive layers, and thereafter these layers are exposed to light, whereby the patterns of the main plates are printed on the photo-sensitive layers on both the faces of the shadow mask. After the exposed photo-sensitive layers have been developed, the unexposed portions are removed from the photo-sensitive layers. Accordingly, resist layers which have patterns corresponding to the patterns of the main plates are formed on the shadow mask material. Then, the shadow mask material is etched at its both faces to form apertures which penetrate the shadow mask material.

In order that apertures are formed by etching both the faces of the shadow mask material as described above, the centers of each pair of the etched concave portions in both the faces of the shadow mask, which are deepened and finally merge, must be aligned. In view of the manufacturing technique, however, it is extremely difficult that the positions of the patterns formed on each main plate coincide with each other over the overall shadow mask.

A pair of main plates will be manufactured as follows:

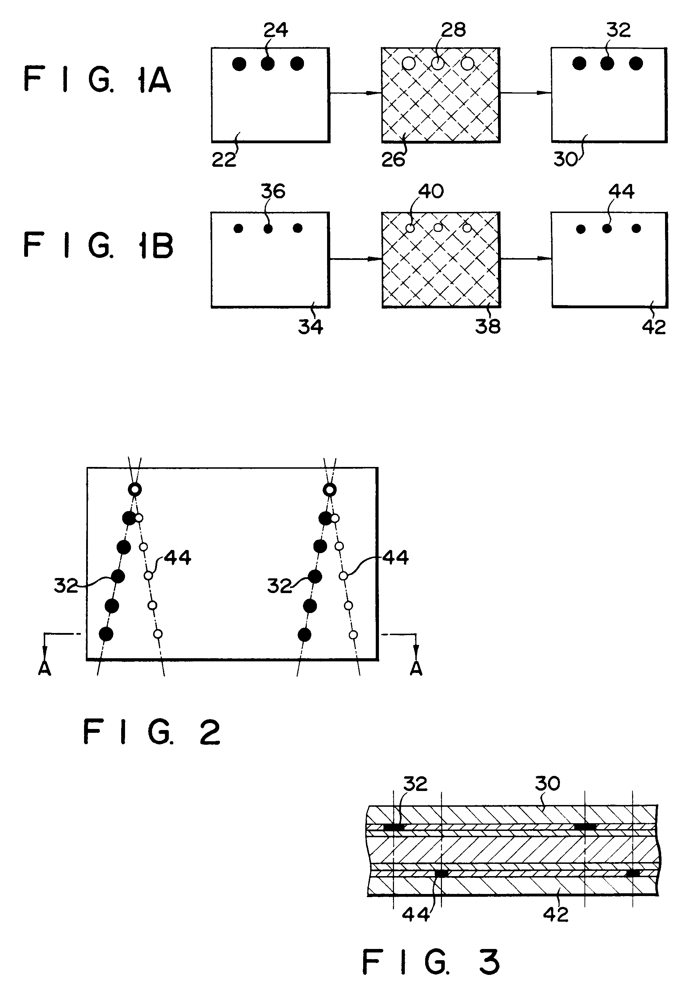

Fig. 1A shows a method of manufacturing a main plate to be closely contacted with the face of a shadow mask material at the side of the phosphor screen, and
Fig. 1B illustrates how to fabricate a main plate to be closely contacted with the face of the shadow mask material at the side of the electron gun.

As shown in Fig. 1A, a pattern 24 for etching the face of the shadow mask material at the side of the phosphor screen is drawn by a pattern drawing device on a negative dry plate 22. The dry plate 22 is developed to form a first negative pattern plate at the side of the phosphor screen. Next, a similar negative dry plate 26 is closely contacted with the first negative pattern plate at the side of the phosphor screen and printed. By developing the dry plate 26, a positive pattern 28 is formed. Thus, a positive pattern plate having the positive pattern 28 is manufactured which is used as a master. Further, a negative dry plate 30 is closely contacted with the positive pattern plate and printed, and the development of the negative dry pattern 30 creates a pattern 32, whereby a second negative pattern plate having the pattern 32 at the side of the phosphor screen is formed which is used as a first main plate for forming the apertures of a shadow mask.

A pattern 36 for etching the face of the shadow mask material at the side of the electron gun is drawn by the pattern drawing device on a negative dry plate 34 as shown in Fig. 1B. The dry plate 34 is developed to form a first negative pattern plate at the side of the electron gun. Next, a similar negative dry plate 38 is closely contacted with the first negative pattern plate at the side of the electron gun and printed. By developing the dry plate 38, positive pattern 40 is formed, whereby a positive pattern plate is manufactured which is used as a master. A negative dry plate 42 is closely contacted with this positive pattern and printed. The dry plate 42 is developed to form a pattern 44, whereby a second negative pattern plate having the pattern 44 at the side of the electron gun is formed which is used as a second main plate for forming the apertures of a shadow mask.

There are two reasons why each pair of main plates are manufactured by the above-described method.

First, since the image of the first negative pattern plate is inverted and the positive pattern plate is produced, inequality of patterns can be easily found which might be caused by such defects as small deviation in pattern dimensions and irregularity of the patterns. It should be noted that negative patterns formed by the pattern drawing device have a high light transmittance, making it difficult to find the above-mentioned defects, whereas the above-described positive patterns have a low light transmittance, making it relatively easy to find the above defects.

Secondly, when the positive pattern plates are used as masters, a great number of main plates can be directly produced.

With the shadow mask of a conventional color cathode ray tube used for a commercial purpose, apertures with a required shape and accuracies can be formed by means of a pair of main plates made by the above-mentioned method. Since, however, with the shadow mask of a color cathode ray tube such as display tube, in which a high resolution is required, the apertures are small and arranged at a small pitch. Accordingly, it is difficult to form apertures with a required shape and accuracies in main plates manufactured by the above method. It is because positional displacement tolerances are small for a pair of main plates. In other words, it is because a small positional displacement tolerance is allowed between the pattern on the shadow mask at the side of the phosphor screen which corresponds to the pattern of the first main plate bearing the apertures at the side of the phosphor screen, as one party, and the pattern on the shadow mask at the side of the electron gun which corresponds to the pattern of the second main plate bearing the apertures at the side of the electron gun, as the other party. For this purpose, the deviation of alignment between those etched concave portions in both the faces of the shadow mask, which are formed from the patterns of the two main plates must be less than 3 microns. A factor which causes such displacement between the patterns of a pair of main plates is that a problem exists in the way in which the patterns are described on a first dry plate by a pattern drawing device when the paired main plates are manufactured. In more detail, when a pattern drawing device is used, patterns are drawn in the same direction of the order of the rows of the patterns, that is, from the first row to the n'th row (n>1) on a pair of dry plates. When the patterns are drawn on dry plates at an angle even slightly different from the angle required for the pattern, the patterns of the paired dry plates are drawn similarly in a state inclined from the required angle due to the function and the drawing accuracy of the main pattern drawing device. In this case, the positional displacement between the upper end and the lower end of the patterns in the outermost n'th row of the shadow mask for a 20-inch color cathode ray tube, for example, is 5 to 7 microns. Patterns are drawn by the main pattern drawing device on both dry plates with their emulsion faces disposed upward, and thereafter both dry plates are placed on the other dry plates such that their emulsion faces are directed to those of the other dry plates, and the patterns of both the dry plates are transcribed to the other dry plates to form positive pattern plates each having a positive pattern. The pattern of the positive pattern plate is also transcribed to further dry plates, thereby manufacturing a pair of main plates.

Figs. 2 and 3 show a pattern formed on a main plate closely contacted with a shadow mask material when a shadow mask is manufactured. When a pair of main plates are used for printing a shadow mask, the emulsion faces formed with patterns are directed to the photo-sensitive layers of the corresponding faces of a shadow mask material and are closely contacted therewith. Upon printing the patterns on the shadow mask material, the first and second main plates are directed to the corresponding faces of the shadow mask material and placed thereon such that the pattern in the first row on the first main plate and the pattern of the last row on the second main plate form, on the shadow mask material, apertures which coincide with each other. If the rows of the patterns to be formed on the shadow material are inclined from the required angle, the inclinations of these rows of the patterns on the first and second main plates are reversely directed as shown in Fig. 2, because the two patterns face the corresponding faces of the shadow mask material. As a result, each pair of patterns on the shadow mask material are greatly displaced from each other as shown in Fig. 2.

From JP-A-53-33568 there is known a pattern formation device for a shadow mask which is capable of simultaneously forming larger-opening and smaller-opening printing patterns on front and rear surfaces of a shadow mask. For this purpose undeveloped glass plates are fixed with the emulsion surface turned outside to the respective two sides of a XY movable printing table, and after pattern position alignment the two sides are printed simultaneously by irradiating the glass plates from opposite directions. Thus, changes in room temperature or in other environmental conditions occuring between front and reverse side exposures can be prevented from having adverse influence on pattern accuracy.

The object of this invention is to provide a method of manufacturing main plates for exposure printing in which the patterns formed on a pair of main plates can accurately coincide with each other on both the faces of a member to be exposed to light when the patterns are printed on photo-sensitive layers formed on both the faces of the member.

The method of manufacturing main plates for exposure printing comprises the step of drawing a pattern on each of a pair of original dry plates and developing the pattern on each of the pair of original dry plates, and the step of successively performing transcription of the developed pattern formed on one of the pair of original dry plates even times in such a manner that a transcribed pattern having just formed on a newly supplied dry plate at a prior transcription is now transcribed to a freshly supplied dry plate at a next transcription, and successively performing transcription of the developed pattern formed on the other one of the pair of original dry plate odd times in such a manner that a transcribed pattern having just formed on a newly supplied dry plate at a prior transcription is now transcribed to a freshly supplied dry plate at a next transcription, thereby forming a pair of main plates.

This invention has the technical features that the patterns of a pair of main plates which are closely contacted with both the faces of a member to be exposed to light can be very accurately coincide with each other.

This invention can be more fully understood from the following detailed description when taken in conjunction with the accompanying drawings, in which:
Figs. 1A and 1B are drawings explaining a conventional method of manufacturing a main plate;
Fig. 2 is a drawing showing the displacement of patterns formed on both the faces of a shadow mask;
Fig. 3 is a longitudinal cross-sectional view of the shadow mask material together the main plates along line A-A in Fig. 2;
Fig. 4 is a longitudinal cross-sectional view of a cathode ray tube;
Fig. 5 is a cross-sectional view of the shadow mask having holes;
Fig. 6 is a cross-sectional view showing the state of a shadow mask material and main plates in which the photo-sensitive layers on both the faces of the shadow mask material are exposed to light;
Figs. 7A and 7B are drawings explaining a method of manufacturing main plates according to this invention;
Fig. 8 shows a size of openings formed in each of both the faces of a shadow mask material;
Fig. 9A shows the displacement of a pattern formed on a first negative pattern of this invention;
Fig. 9B explains the displacement of a pattern formed on a shadow mask; and
Fig. 10 shows a pattern formed on the shadow mask.

Embodiments according to this invention will be explained with reference to the accompanying drawings.

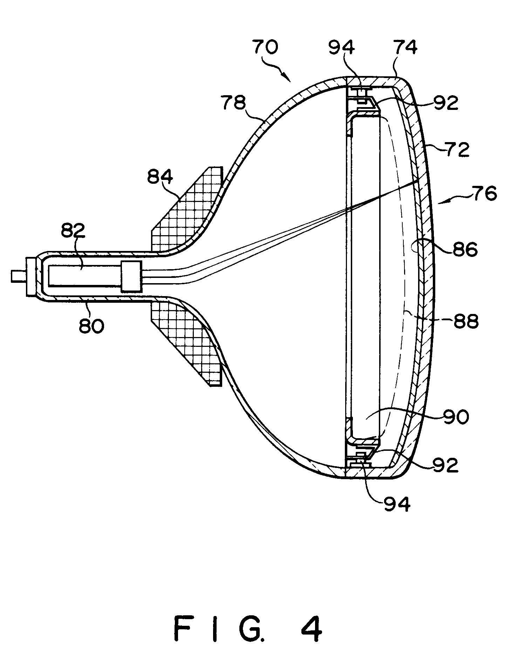

Fig. 4 shows a color cathode ray tube having a shadow mask. The tube 70 is provided with a panel 76 having a substantially rectangular face plate 72 and a skirt 74 extending rearward from the periphery of the face plate 72, a funnel 78 connected to the skirt 74 of the panel 76, and a neck 80 formed continuous to the funnel 78. The interior of the color cathode ray tube 70 is held in vacuum by the panel 76, the funnel 78 and the neck 80. In the neck 80 is housed an electron gun assembly 82 which generates three electron beams. A deflection yoke 84 is mounted on the outer surfaces of the funnel 78 and the neck 80. On the inner face of the face plate 72 is formed a phosphor screen 86 which has three kinds of phosphor layers alternately arranged in a stripe manner. The phosphor layers emit red, green or blue light shot by three electron beams, respectively. A substantially rectangular shadow mask 88 made of a thin metal plate having a plurality of apertures is disposed opposed to the phosphor screen 86 in the tube 70. The shadow mask 88 serves to land the three electron beams from the electron gun assembly 82 on the corresponding phosphor layers. A metal mask frame 90 is arranged round the shadow mask 88. A plurality of elastically deformable supports 92 are welded to the mask frame 90. A plurality of panel pins 94 are arranged on the inner face of the skirt 74.

After the three electron beams emitted from the electron gun assembly 82 are deflected vertically and horizontally by the magnetic field generated by the deflection yoke 84, they converge towards the aperture of the shadow mask 88. The electron beams passing the aperture are landed on the phosphor screen 86 formed on the panel 76. The three kinds of layers alternately formed on the phosphor screen 86 emit red, green or blue light after the three electron beams pass the aperture of the shadow mask 88. In other words, the apertures of the shadow mask 88 allot the three electron beams to the predetermined phosphor layers which emit red, green or blue light.

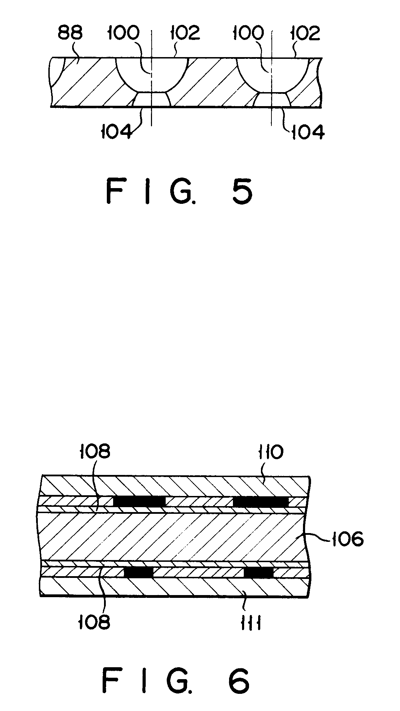

As shown in Fig. 4, the shadow mask 88 has a great number of apertures. Fig. 5 shows a longitudinal cross-sectional view including these apertures 100, each of which has an opening 102 at the side of the phosphor screen and another opening 104 at the side of the electron gun. The opening 102 at the side of the phosphor screen is larger than the opening 104 at the side of the electron gun, and an approximately middle portion of the aperture 100 has the minimum diameter such that the aperture 100 takes a so-called drum shape. This shape enables the electron beams to be reflected to the inner wall of the aperture 100 to prevent them from being shot to the other areas than the phosphor layers.

The apertures 100 of the shadow mask 88 are formed by a photo-etching method. The shadow mask 88 is made of a plate-like shadow mask material 106 of low carbon steel. As shown in Fig. 6, photo-sensitive layers 108 are formed on both the faces of the shadow mask material 106. The layers 108 are closely contacted with a pair of main plates 110 and 111 formed with dot patterns corresponding to the apertures 100 and exposed to light, whereby the patterns of the main plates 110 and 111 are printed on the photo-sensitive layers 108. After developing the photo-sensitive layers 108, the unexposed portions of the photo-sensitive layers 108 are removed. Therefore, resist layers having the patterns corresponding to the patterns of the main plates 110 and 111 are formed on the shadow mask material 106. Thereafter, the apertures 100 penetrating the shadow mask material 106 are opened by etching the material 106 at its both faces.

A pair of main plates will be manufactured as follows:

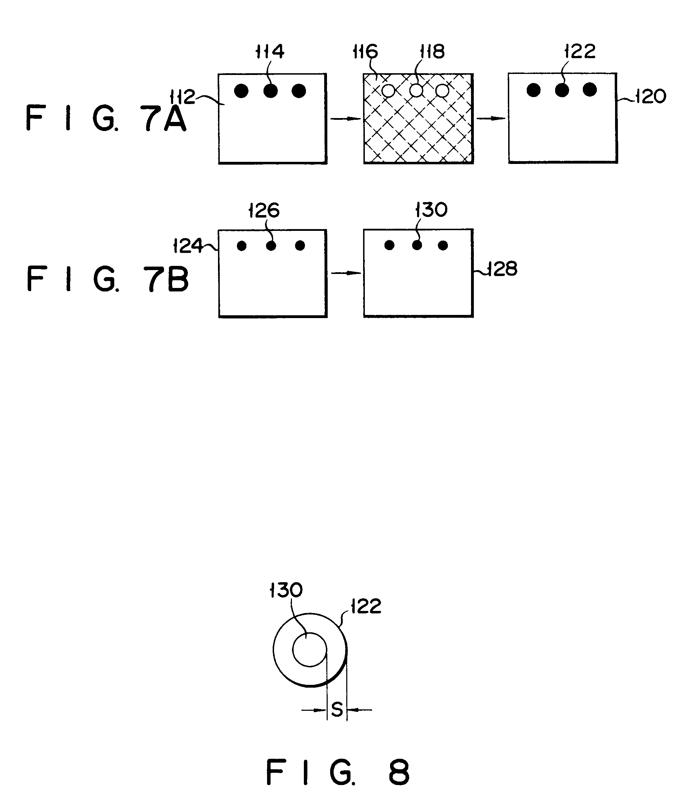

Fig. 7A shows a method of manufacturing a main plates 110 closely contacted with the face of the shadow mask material 106 at the side of the phosphor screen, and Fig. 7B shows how to fabricate a main plate 111 closely contacted with the face of the shadow mask material 106 at the side of the electron gun.

In Fig. 7A, a dot pattern 114 corresponding to the apertures 100 is drawn on a negative original dry plate 112 by a pattern drawing device (not shown). After developing the dry plate 112, a first negative pattern plate is formed. Next, a similar negative dry plate 116 is closely contacted with the first negative pattern plate and printed. Then, the dry plate 116 is developed to produce a positive pattern 118 from which a positive pattern plate used as a master is made. A negative dry plate 120 is closely contacted with the positive pattern plate and printed. After the development of the negative dry plate 120, a second negative pattern plate having a pattern 122 is formed. Thus, the second negative pattern plate is formed as the main plate 110.

In Fig. 7B, a dot pattern 126 corresponding to the apertures 100 is drawn on a negative original dry plate 124 by the pattern drawing device. After developing the dry plate 124, a negative pattern plate is formed. A positive dry plate 128 is closely contacted at its emulsion face with the negative pattern plate. After developing the dry plate 128, a negative pattern 130 is printed to form a positive pattern plate having the negative pattern 130, which is used as the main plate 111.

With the main plates 110 and 111 manufactured by the above method, the apertures 100 can be formed which has a shape and accuracies required for the shadow mask 88.

The shadow mask of a color cathode ray tube, such as a display tube, which requires a high resolution has small apertures arranged at a small pitch.

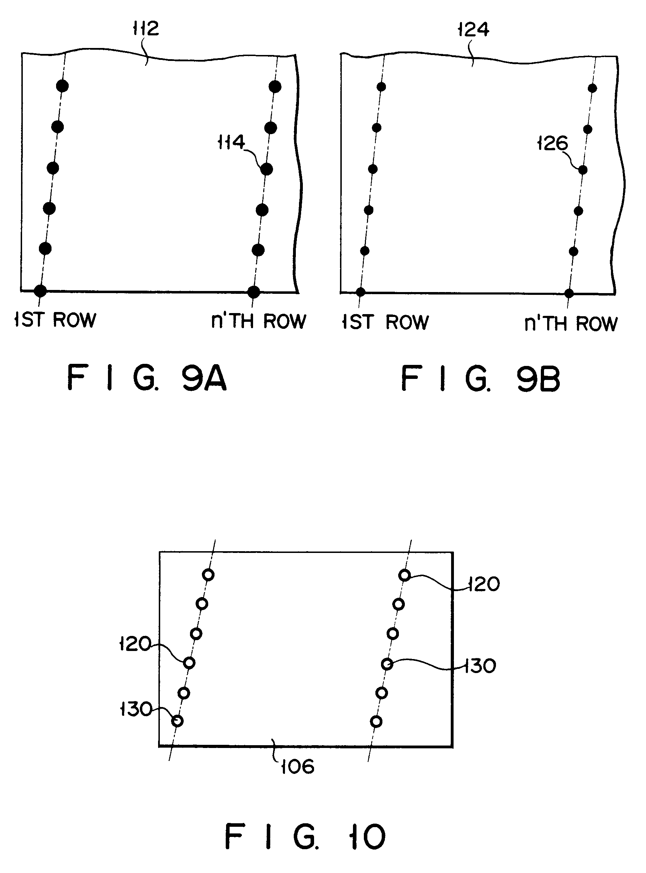

As shown in Fig. 8, with a pair of main plates 110 and 111 for manufacturing a color cathode ray tube having a high resolution, the displacement tolerance S between the pattern 122 and the pattern 130 is small. The dry plates 112 and 124 on which patterns are drawn by the pattern drawing device are shown in Figs. 9A and 9B, respectively. Patterns are drawn in turn in the same direction of the order of the rows of the patterns, that is, from the first order to the n'th order (n>1). When the patterns are drawn on the dry plates 112 and 114 at an angle even slightly different from the angle required for the patterns, the patterns 112 and 114 of the paired main plates 110 and 111 are similarly inclined. When the paired main plates 110 and 111 are used for printing a shadow mask, the emulsion faces in which the patterns are to be formed are closely contacted with the photo-sensitive layers on both the faces of the shadow mask material 106.

Fig. 10 shows a shadow mask material 106, the pattern 120 of a main plate 110 and the pattern 130 of a main plate 111. When the patterns are printed on the shadow mask 106, the main plates are disposed to face each other such that the apertures in the first row on the main plate 110 coincide with the apertures in the first row on the main plate 111. If the rows of the patterns to be formed on the shadow mask material are inclined from the required angle, the inclinations of the rows of the two patterns are same, because the patterns face each other on the respective faces of the shadow mask material. As a result, the positional displacement between the paired etched concave portions formed in both the faces of the shadow mask material is remarkably reduced.

When a shadow mask for a 20-inch color cathode ray tube with a high resolution was manufactured according to this invention, the pattern displacement was less than 3 microns over the whole area of the shadow mask. In this case, the diameter of the dot of the pattern of the main plate was 0.130 mm, the diameter of the dot of the pattern of the main plate 111 was 0.06 mm and the pitch of the dot of the patterns was 0.250 mm.

In the above embodiment, a negative plate having a positive pattern can be made for finding inequality of the patterns. With the above embodiment, a negative dry plate is closely contacted with either the dry plate 124 or the dry plate 128 and then printed, thereby forming the pattern plate having the positive pattern. By using this pattern plate, small deviation of the pattern dimensions and the irregularity of the pattern can be easily detected.

In the above embodiment, the pattern on the main plate 110 bears the aperture images corresponding to the larger apertures at the side of the phosphor screen and the pattern on the other main plate 111 bears the aperture images corresponding to the smaller apertures at the side of the electron gun. However, the scope of this invention is not limited to this arrangement, but the diameters of the aperture images at the side of the phosphor screen and at the side of the electron gun can be reversed.

This method of the invention is not limited to a method of manufacturing main plates for a shadow mask of a color cathode tube, but is applicable to a method of manufacturing a pair of main plates disposed opposite to or closely contacted with photo-sensitive layers formed on both faces of the other kind of plate-like member to be exposed to light.

According to this invention, the apertures of a shadow mask are accurately arranged and regularly shaped. This enhances the resolution of a color cathode ray tube having this shadow mask.

## Claims

1. A method of manufacturing main plates for exposure printing, said main plates having patterns (114, 126) disposed opposite to or closely contacted with photo-sensitive layers (108) formed on both faces of a plate-like member such that said patterns are printed on said photo-sensitive layers by being exposed to light, characterized in that said patterns (114, 126) are drawn on a pair of original dry plates (112, 124) and developed; the developed pattern formed on one of said pair of original dry plates is successively transcribed even times in such a manner that a transcribed pattern having just formed on a newly supplied dry plate at a prior transcription is now transcribed to a freshly supplied dry plate at a next transcription, and the developed pattern formed on the other one of said pair of original dry plate is successively transcribed odd times in such a manner that a transcribed pattern having just formed on a newly supplied dry plate at a prior transcription is now transcribed to a freshly supplied dry plate at a next transcription, whereby a pair of main plates (120, 128) are manufactured.

2. The method according to claim 1, characterized in that said pair of original dry plates (112, 124) are of negative type.

3. The method according to claim 1, characterized in that the dry plates used for manufacturing the main plate to which the pattern of said one of said pair of original dry plates (112) is transcribed are of negative type, and at least one of the dry plates used for manufacturing the main plate to which the pattern of said other one of said pair of original dry plates (124) is transcribed is of positive type.

4. The method according to claim 1, characterized in that two negative dry plates are used for manufacturing the main plate to which the pattern of said one of said pair of original dry plates (112) is transcribed, and a positive dry plate is used for manufacturing the main plate to which the pattern of said other one of said pair of original dry plates (124) is transcribed.

5. The method according to claim 1, characterized in that new dry plates are closely contacted with dry plates which bear said patterns (114, 126) and are printed, and then the patterns on said dry plates are transcribed to said new dry plates after being developed.

6. The method according to claim 1, characterized in that said plate-like member comprises a metal plate for manufacturing a shadow mask of a color cathode ray tube.

7. The method according to claim 1, characterized in that said patterns (114, 126) drawn on said pair of original dry plates (112, 124) comprise dots drawn in a lattice form by a pattern drawing device such that both the faces of a shadow mask of a color cathode tube are etched at said dots.

8. The method according to claim 7, characterized in that the dots drawn on one of said pair of original dry plates are larger in diameter than the dots drawn on the other one of said pair of original dry plates.

9. The method according to claim 1, characterized in that said pair of original dry plates are disposed opposite to said plate-like member or closely contacted therewith such that the same rows of aperture images of the patterns on said pair of original dry plates face each other and coincide with each other.

10. The method according to claim 1, characterized in that said pair of dry plates for transcribing the pattern to said pair of main plates are used as masters.

## Patentansprüche

1. Verfahren zur Herstellung von Haupt- bzw. Druckplatten für das Drucken mittels Belichtung, wobei die Druckplatten Muster (114, 126) aufweisen, die sich in Gegenüberstellung zu oder in inniger Berührung mit auf beiden Flächen eines plattenartigen Elements geformten lichtempfindlichen Schichten (108) befinden, so daß die Muster durch Belichtung auf den lichtempfindlichen Schichten abgedruckt werden, dadurch gekennzeichnet, daß die Muster (114, 126) auf zwei Vorlagentrockenplatten (112, 124) (auf)gezeichnet und entwickelt werden; daß das auf einer der beiden Vorlagentrockenplatten geformte entwickelte Muster aufeinanderfolgend mit einer geraden Häufigkeitszahl in der Weise übertragen wird, daß ein übertragenes Muster, das eben auf einer neu zugelieferten Trockenplatte bei einer früheren Übertragung geformt worden ist, nunmehr in einer nächsten Übertragung auf eine frisch zugelieferte Trockenplatte übertragen wird; und daß das auf der anderen der beiden Vorlagentrockenplatten geformte entwickelte Muster aufeinanderfolgend mit einer ungeraden Häufigkeitszahl in der Weise übertragen wird, daß ein übertragenes Muster, das eben auf einer neu zugelieferten Trockenplatte bei einer früheren Übertragung geformt worden ist, nunmehr in einer nächsten Übertragung auf eine frisch zugelieferte Trockenplatte übertragen wird, wodurch zwei Druckplatten (120, 128) hergestellt werden.

2. Verfahren nach Anspruch 1, dadurch gekennzeichnet, daß die beiden Vorlagentrockenplatten (112, 124) vom Negativtyp sind.

3. Verfahren nach Anspruch 1, dadurch gekennzeichnet, daß die Trockenplatten zur Herstellung der Druckplatte, auf welche das Muster der einen der beiden Vorlagentrockenplatten (112) übertragen wird oder ist, vom Negativtyp sind und mindestens eine der Trockenplatten zur Herstellung der Druckplatte, auf welche das Muster der anderen der beiden Vorlagentrockenplatten (124) übertragen wird oder ist, vom Positivtyp ist.

4. Verfahren nach Anspruch 1, dadurch gekennzeichnet, daß zwei negative Trockenplatten zur Herstellung der Druckplatte, auf die das Muster der einen der beiden Vorlagentrockenplatten (112) übertragen wird oder ist, benutzt werden und eine positive Trockenplatte zur Herstellung der Druckplatte, auf die das Muster der anderen der beiden Vorlagentrockenplatten (124) übertragen wird oder ist, benutzt wird.

5. Verfahren nach Anspruch 1, dadurch gekennzeichnet, daß neue Trockenplatten innig mit die Muster (114, 126) tragenden Trockenplatten in Berührung gebracht und bedruckt werden und sodann die Muster auf den Trockenplatten nach der Entwicklung auf die neuen Trockenplatten übertragen werden.

6. Verfahren nach Anspruch 1, dadurch gekennzeichnet, daß das plattenartige Element eine Metallplatte zur Herstellung einer Lochmaske einer Farbkathodenstrahlröhre umfaßt.

7. Verfahren nach Anspruch 1, dadurch gekennzeichnet, daß die auf den beiden Vorlagentrockenplatten (112, 124) (auf)gezeichneten Muster (114, 126) Punkte umfassen, die in einer Gitterform mittels einer Musterzeichnungsvorrichtung so (auf)gezeichnet wurden, daß beide Flächen einer Lochmaske einer Farbkathodenstrahlröhre an den Punkten geätzt werden.

8. Verfahren nach Anspruch 7, dadurch gekennzeichnet, daß die auf einer der beiden Vorlagentrockenplatten (auf)gezeichneten Punkte einen größeren Durchmesser aufweisen als die auf der anderen der beiden Vorlagentrockenplatten (auf)gezeichneten Punkte.

9. Verfahren nach Anspruch 1, dadurch gekennzeichnet, daß die beiden Vorlagentrockenplatten in Gegenüberstellung zum plattenartigen Element oder in innige Berührung mit diesem gebracht werden, derart, daß die gleichen Reihen von Lochbildern der Muster auf den beiden Vorlagentrockenplatten einander zugewandt sind und miteinander übereinstimmen.

10. Verfahren nach Anspruch 1, dadurch gekennzeichnet, daß die beiden Trockenplatten zum Übertragen des Musters auf die beiden Druckplatten als Muttermatrizen oder Schablonen (masters) benutzt werden.

## Revendications

1. Procédé de fabrication de plaques principales pour impression par exposition, lesdites plaques principales comportant des motifs (114, 126) disposés de manière à faire face à des couches photosensibles (108) formées sur les deux faces d'un élément en forme de plaque ou de manière à être en contact intime avec de telle sorte que lesdits motifs soient imprimés sur lesdites couches photosensibles en étant exposés à une lumière, caractérisé en ce que lesdits motifs (114, 126) sont dessinés sur une paire de plaques sèches originales (112, 124) et sont développés ; le motif développé formé sur l'une de ladite paire de plaques sèches originales est successivement transcrit à des instants pairs de telle sorte qu'un motif transcrit qui vient juste d'être formé sur une plaque sèche nouvellement appliquée lors d'une transcription antérieure soit maintenant transcrit sur une plaque sèche appliquée fraîchement lors d'une transcription suivante, et le motif développé formé sur l'autre de ladite paire de plaques sèches originales est successivement transcrit à des instants impairs de telle sorte qu'un motif transcrit qui vient juste d'être formé sur une plaque sèche nouvellement appliquée lors d'une transcription antérieure soit maintenant transcrit sur une plaque sèche appliquée fraîchement lors d'une transcription suivante et ainsi, une paire de plaques principales (120, 128) sont fabriquées.

2. Procédé selon la revendication 1, caractérisé en ce que les plaques de ladite paire de plaques sèches originales (112, 124) sont du type négatif.

3. Procédé selon la revendication 1, caractérisé en ce que les plaques sèches utilisées pour la fabrication de la plaque principale sur laquelle le motif de ladite une (112) de ladite paire de plaques sèches originales est transcrit sont du type négatif et au moins l'une des plaques sèches utilisées pour la fabrication de la plaque principale sur laquelle le motif de ladite autre (124) de ladite paire de plaques sèches originales est transcrit est du type positif.

4. Procédé selon la revendication 1, caractérisé en ce que deux plaques sèches négatives sont utilisées pour la fabrication de la plaque principale sur laquelle le motif de ladite une (112) de ladite paire de plaques sèches originales est transcrit et une plaque sèche positive est utilisée pour la fabrication de la plaque principale sur laquelle le motif de ladite autre (124) de ladite paire de plaques sèches originales est transcrite.

5. Procédé selon la revendication 1, caractérisé en ce que de nouvelles plaques sèches sont mises en contact intime avec des plaques sèches qui sont porteuses desdits motifs (114, 126) et sont imprimées, puis les motifs sur lesdites plaques sèches sont transcrits sur lesdites nouvelles plaques sèches après avoir été développés.

6. Procédé selon la revendication 1, caractérisé en ce que ledit élément en forme de plaque comprend une plaque en métal pour fabriquer un masque perforé d'un tube à rayons cathodiques couleur.

7. Procédé selon la revendication 1, caractérisé en ce que lesdits motifs (114, 126) dessinés sur ladite paire de plaques sèches originales (112, 124) comprennent des points dessinés selon une forme de réseau par un dispositif de génération de dessin de motif de telle sorte que les deux faces d'un masque perforé d'un tube à rayons cathodiques couleur soient gravées au niveau desdits points.

8. Procédé selon la revendication 7, caractérisé en ce que les points dessinés sur l'une de ladite paire de plaques sèches originales sont d'un diamètre plus important que celui des points dessinés sur l'autre de ladite paire de plaques sèches originales.

9. Procédé selon la revendication 1, caractérisé en ce que les plaques de ladite paire de plaques sèches originales sont disposées de manière à faire face audit élément en forme de plaque ou sont mises en contact intime avec de telle sorte que les mêmes rangées d'images de cavités des motifs sur ladite paire de plaques sèches originales se fassent face les unes les autres et coïncident les unes avec les autres.

10. Procédé selon la revendication 1, caractérisé en ce que les plaques de ladite paire de plaques sèches pour transcrire le motif sur ladite paire de plaques principales sont utilisées en tant que maîtres.
